# EUROPÄISCHE PATENTSCHRIFT

(11) **EP 1 037 058 B1**
(45) Veröffentlichungstag und Bekanntmachung des Hinweises auf die Patenterteilung: **02.02.2005**
(21) Anmeldenummer: 99810239.6
(22) Anmeldetag: 18.03.1999
(51) Int. Cl.: G01R 23/12, G01B 7/34

(54) **Elektronische Frequenzmesseinrichtung und ihre Verwendung**
Electronic frequency measuring device and its utilisation
Dispositif électronique de mesure de la fréquence et son utilisation

(43) Veröffentlichungstag der Anmeldung: 20.09.2000
(73) Patentinhaber: Nanosurf AG, 4410 Liestal (CH)
(72) Erfinder: Battiston, Felice M., 4132 Muttenz (CH); Müller, Dominik M., 4110 Liestal (CH)
(74) Vertreter: Barth, Carl Otto, Dipl.-Ing.

(56) Entgegenhaltungen:
- EP-A- 0 551 814
- EP-A- 0 661 815
- DE-A- 4 328 097
- US-A- 5 753 814
- LOPPACHER CH.: 'Fast digital electronics for application in dynamic force microscopy using high-Q cantilevers' APPL.PHYS.A Bd. 66, DE, Seiten S215 - S218

## Beschreibung

### Technisches Gebiet der Erfindung

Die Erfindung liegt auf dem Gebiet der Frequenzmessung, insbesondere der äusserst präzisen Differenzfrequenzmessung, wie sie im Messgeräte-Bereich benutzt wird. Solche präzisen Frequenzmessungen sind z. B. für Rasterkraftmikroskope und andere abtastende Mikroskope, sog. Rastersondenmikroskope (Scanning Probe Microscopes), erforderlich, wenn deren Schwingungseigenschaften zur Messung eingesetzt werden. Im Bereich der Thermo-Gravimetrie können sie zur Bestimmung von äusserst kleinen Massen im ng-Bereich benutzt werden. Im einzelnen betrifft die Erfindung das Prinzip eines solchen hybriden, d.h. digitale und analoge Bauteile oder Baugruppen aufweisenden Frequenzmessers oder Frequenzdetektors. Sie betrifft ausserdem eine besonders vorteilhafte Verwendung eines solchen Frequenzdetektors zur Auswertung der Frequenz-Messungen eines Rastersondenmikroskops. So kann beispielsweise eine erfindungsgemässe Frequenzmessanordnung in einem Messkopf eines Rastersondenmikroskops zumindest partiell integriert werden, was eine robuste und gleichzeitig empfindliche Messanordnung ermöglicht, die Vorteile gegenüber dem Stand der Technik aufweist.

### Stand der Technik

In der Rastersondenmikroskopie wird als Sonde vielfach eine elektronische Vorrichtung verwendet, welche die Wechselwirkung zwischen der Sonde und einem Messobjekt, d.h. der Probe, aufnimmt. Dazu werden im wesentlichen zwei Methoden verwendet. Einmal die Kontaktmessung, welche die statische Beeinflussung der Sonde durch die Probe misst, und anderseits die Nichtkontaktmessung welche die Beeinflussung der Sonde durch die Probe als Resonanzfrequenzänderung der Sonde aufnimmt. Da diese Frequenzänderungen jedoch meist sehr klein in Relation zur unbeeinflussten, freien Resonanzfrequenz der Sonde sind, werden hohe Ansprüche an die Sensorelektronik gestellt. Diese muss dann in der Lage sein, die kleinen Signaländerungen der Sonde in eine Spannung oder eine numerische Grösse zu wandeln, die weiterverarbeitet werden kann. Dass dabei eine ganze Reihe von Problemen zu lösen ist, liegt auf der Hand. Es treten nicht nur Temperaturabhängigkeiten und Probleme mit der Langzeitstabilität auf, sondern es muss auch ausreichende Messauflösung und Linearität erzielt werden; selbst Toleranzen der Bauteile müssen in Betracht gezogen werden.

Eine solche Lösung ist beispielsweise von T. Albrecht im Journal of Applied Physics, Vol.69, 1991, pp 668ff, "Frequency Modulation Detection Using High-Q Cantilevers for Enhanced Microscopy Sensitivity" beschrieben. Die dort beschriebene Methode versucht, die Resonanzfrequenzänderung des Sensors mit Hilfe einer bekannten Filtercharakteristik, meist eines Band- oder Tiefpasses, zu ermitteln. Dabei wird die Frequenzabhängigkeit der Transfercharakteristik des verwendeten Filters verwendet, um über die Amplitudenveränderung des Filterausgangsignales bei Frequenzänderung des Filtereingangsignales eine Messgrösse zu erhalten. Mit dieser Methode bzw. einer solchen Sensorelektronik lässt sich zwar eine ausreichend hohe Messauflösung erzielen, ein linearer Zusammenhang zwischen der Frequenzänderung der Sonde und der Ausgangsgrösse der Sensorelektronik ist jedoch nur in einem schmalen Bereich und nur annähernd gegeben. Auch kann die Temperaturunabhängigkeit einer solchen Anordnung nicht immer befriedigen und sie reagiert sehr stark auf Bauteiletoleranzen. Dazu kommt, dass eine solche Sensorelektronik nur schwierig auf unterschiedliche Sensoren mit stark verschiedenen Resonanzfrequenzen und/oder Resonanzfrequenzverschiebungen angepasst werden kann, da hierfür meistens mehrere aufeinander abgestimmte Induktivitäten und/oder Kapazitäten verändert werden müssten.

Ein anderer Lösungsansatz für die beschriebene Aufgabenstellung besteht in einer Frequenzmessung mittels eines analogen PLL-Bausteins, also eines Phase-Locked-Loop-Bausteins. Ein solcher Ansatz ist beispielsweise von Roland E Best in "Phase-Locked Loops, Theorie, Design and Applications", 1st ed., McGraw-Hill, New York, 1984, Kapitel 2, beschrieben. Dort wird mit Hilfe eines analogen PLL ein von einem Sender kommendes Frequenzsignal gemessen. Die bereits aufbereitete Senderschwingung wird als Eingangssignal des PLL-Phasendetektors verwendet und das VCO-Steuersignal, also die den Oszillator des PLL steuernde Spannung, dient als Ausgangsgrösse der Elektronik und wird als Mass für die Frequenzänderung des Senders genommen. Eine solche Anordnung besitzt eine recht gute Linearität und eine gute Rauschunterdrückung, auch sind Bauteiletoleranzen nicht allzu kritisch. Eine gute Messauflösung wird jedoch nur bei eingeschränktem Frequenzmessbereich erzielt, wodurch der Anwendungsbereich begrenzt ist. Auch können Temperatur- und Langzeitstabilität bei einer solchen Anordnung - wie meist bei analogen Schaltungen - nur mit erheblichem Aufwand erzielt werden. Auch kann eine solche Anordnung nur schwer an unterschiedliche Sensoren mit stark differierenden Resonanzfrequenzen und/oder verschiedenen Resonanzfrequenzverschiebungen angepasst werden.

Einen dritten Lösungsansatz geben Ch. Loppacher et al in "Fast digital electronics for application in dynamic force microscope using high-Q cantilevers", Applied Physics A, Band 66, Suppl. (1998), pp S215 - S218, an. Dort ist beschrieben, wie mit Hilfe eines rein digitalen PLL das Frequenzsignal und/oder die Phasenverschiebung eines Sensors gemessen werden kann. Dieser Aufbau löst die meisten Probleme der oben aufgeführten beiden Methoden. Sie ist temperaturunempfindlich, langzeitstabil, linear, leicht anpassungsfähig an verschiedene Sensoren und nahezu unabhängig von Bauteiletoleranzen.

Dafür erfordert sie jedoch einen erheblichen Aufwand an Bauteilen, Raum und elektrische Energie, was sich nicht nur in hohen Kosten niederschlägt, sondern eine solche Lösung für solche Anwendungen, bei denen es auf geringe Grösse und/oder niedrigen Energieverbrauch ankommt, unbrauchbar macht. Natürlich wirken auch die erwähnten hohen Kosten prohibitiv.

Im US-Patent 5 753 814 von Han et al. ist ein Kraftmikroskop mit magnetisch angeregter Sonde beschrieben, bei dem eine hybride Schaltung zur Auswertung benutzt wird. Dabei erfolgt eine Rückkopplung über die magnetische Anregung des Cantilevers.

Eine weitere Methode ist in der Patentanmeldung WO96/24026,"Tapping AFM with Phase or Frequency Detection" beschrieben. Dieser Ansatz zeigt, wie mittels einer oszillierenden Sonde eine Distanzmessung zur Probe erreicht werden kann, wobei ausgenutzt wird, dass die Amplitude der Sondenoszillation von der Distanz zur Probe abhängt. Per Amplitudenmessung kann dann auf die Distanz zur Probe geschlossen werden. Ein Problem dieser Methode ist, dass bei Sonden mit hoher Güte Q sich die Amplitude nur sehr langsam verändert und dadurch auch die Messung sehr langsam ist. Dies macht die beschrieben Methode für alle Messungen, bei denen es auf Schnelligkeit ankommt - dies ist die Mehrzahl der Anwendungen - unbrauchbar. Auch ist die Beziehung zwischen Sondenamplitude und Resonanzfrequenz äusserst kompliziert, was die Interpretation der Messdaten erheblich erschwert.

Aus dem Gesagten ergibt sich die Aufgabe, ein Verfahren und eine Einrichtung, sprich Schaltung, anzugeben, die möglichst alle Vorteile des letztgenannten, voll-digitalen Ansatzes mit erheblich geringerem Aufwand erzielt. Dabei sollen sowohl ausreichende Unabhängigkeit von Temperaturschwankungen und Bauteiltoleranzen als auch eine gute Langzeitstabilität erreicht und es müssen die notwendige Linearität und Messauflösung erzielt werden. M.a.W., es soll eine Lösung gesucht werden, die praktisch die gleichen Vorteile wie die zuletzt beschriebene Methode bietet, jedoch ohne die Probleme von Energie, Raum und Kosten.

### Die Erfindung

In aller Kürze zusammengefasst kann man sagen, dass die Erfindung ein Frequenzdetektor ist, der in sinnreicher - und daher erfinderischer - Weise analoge und digitale Bauweise so kombiniert, dass ein Optimum an Wirkung bei minimalem Aufwand erreicht wird. Im Prinzip arbeitet der Detektor analog in demjenigen Bereich, in dem hohe Reaktionsgeschwindigkeiten und/oder komplizierte mathematische Berechnungen erforderlich sind, während er im Bereich, in dem hohe Genauigkeit, insbesondere Frequenzgenauigkeit, und/oder Stabilität gefordert sind, digital arbeitet und entsprechende Bauteile aufweist.

Ein besonderer Vorteil ist, dass einige der notwendigen, insbesondere analogen Bausteine marktgängig und daher mit geringem Aufwand in guter Qualität erhältlich sind. Andererseits kann der gesamte Digitalteil z.B. mittels eines Mikroprozessors und entsprechender Software implementiert werden, was nahezu unbeschränkte Flexibilität erlaubt.

Zwar sind hybride Schaltungen im Prinzip bekannt, z.B. aus der EP-Patentanmeldung 661 815, "Frequency Synthesizer", nur kann eine solche Schaltung eben nur eine Frequenz erzeugen und nicht die obige Aufgabe erfüllen, nämlich beispielsweise die hochpräzise und schnelle Messung einer Eingangsfrequenz relativ zu einer Referenzfrequenz durchführen.

In einer bevorzugten Ausführungsform der Erfindung, die nachfolgend im Ausführungsbeispiel erläutert werden wird, ergibt sich ein weiterer Vorteil durch eine besonders sinnreiche Anordnung des A/D-Übergangs. Dieser kann nämlich so gelegt werden, dass ein und derselbe Frequenzdetektor praktisch gleichzeitig sowohl ein analoges wie ein digitales Ausgangssignal abgeben kann, was wiederum eine Flexibilität garantiert, wie sie mit den bisherigen Lösungen nicht erzielt werden konnte.

Auch lässt sich die Erfindung sehr einfach anpassen und kann in einfacher Weise so modifiziert werden, dass verschiedene Sensoren verwendet werden können, z.B. neben selbstschwingenden Sensoren auch fremdangetriebene, wobei der phasen- und frequenzkorrekte Antrieb von einer Schaltung gemäss der Erfindung lieferbar ist. Ein Ausführungsbeispiel für diese Modifikation ist ebenfalls nachfolgend gezeigt.

Zusammenfassend kann die Erfindung beschrieben werden als elektronische Frequenzmesseinrichtung, die besonders zur Präzisionsmessung kleiner Frequenzdifferenzen geeignet ist und sich durch eine vorteilhafte hybride Bauweise auszeichnet, wobei sie im wesentlichen drei Baugruppen enthält:
- eine analoge Eingangsgruppe, der ein Signal mit einer zu messenden Eingangsfrequenz und ein analoges Rückkopplungssignal zugeführt werden und die daraus ein die Frequenzdifferenz zwischen Eingangsfrequenz und einer gegebenen Referenzfrequenz abbildendes, analoges Differenzsignal bildet,
- eine digitalen Mischgruppe, die die Abweichung des Differenzsignals von der Referenzfrequenz als digitale Frequenzdifferenz ermittelt, und
- eine analoge Ausgangsgruppe, die aus der digitalen Frequenzdifferenz das Rückkopplungssignal bildet.

Als Erweiterung ist insbesondere die Möglichkeit der Ausgabe eines synchronisierten Frequenz-Steuersignals z.B. zur Ansteuerung eines nicht selbstschwingenden Sensors.

Insgesamt bietet die hier vorgestellte Lösung im wesentlichen die gleichen Vorteile der letztgenannten Methode des Standes der Technik, löst jedoch elegant die dort aufgeführten Probleme von Energie, Raum und Kosten.

Weitere vorteilhafte Ausführungsformen ergeben sich aus der nachfolgenden Beschreibung der Ausführungsbeispiele und aus den Patentansprüchen.

### Ausführungsbeispiele

Nachfolgend werden zwei Ausführungsbeispiele der Erfindung in Verbindung mit den Zeichnungen näher beschrieben. In diesen zeigen:
- Fig. 1: eine Ansicht eines ersten Ausführungsbeispiels der Erfindung;
- Fig. 2: eine Ansicht eines zweiten, modifizierten Ausführungsbeispiels.

### Bezugszeichenliste

| **Fig. 1** | |
|---|---|
| E | Eingangsleitung |
| A | analoge Ausgangsleitung |
| D | digitale Ausgangsleitung |
| 1 | selbstschwingender Sensor |
| 2 | Phasendetektor |
| 3 | Regler |
| 4 | A/D-Wandler |
| 5 | erster Phasenakkumulator |
| 6 | Filter |
| 7 | D/A-Wandler |
| 8 | Lookup-Tabelle |
| 9 | Addierglied |
| 10 | zweiter Phasenakkumulator |
| 11 | Register für Refererenz-Frequenz |
| 12 | Computer |
| 13 | Systemuhr |

| **Fig. 2 (zusätzlich)** | |
|---|---|
| T | Treiberleitung (für Sensor) |
| 14 | angetriebener Sensor |
| 15 | Phasenschieber |

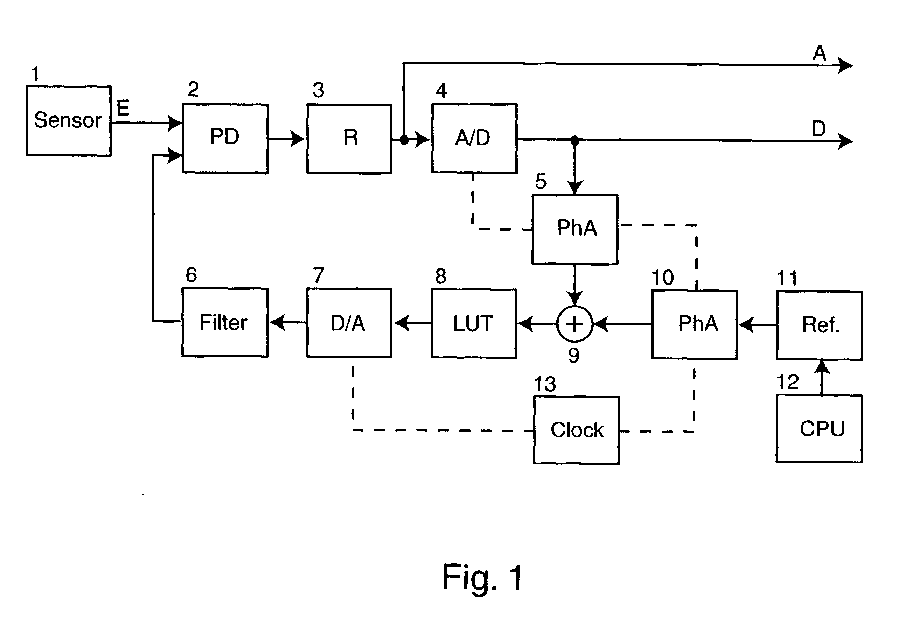

Fig.1 zeigt ein Blockschaltbild einer nachfolgend als erstes Ausführungsbeispiel der Erfindung beschriebenen Schaltung.

Wie oben bereits erwähnt, soll mit der gezeigten Schaltung die Frequenzabweichung eines analogen Eingangssignals, welches das Ausgangssignal eines Sensors 1 ist, bezüglich einer Referenzfrequenz, also eine Differenzfrequenz, gemessen werden. Dabei sollen die Nachteile der bekannten, oben erwähnten Lösungen vermieden werden.

Der in Fig. 1 gezeigten Schaltung wird die zu messende Frequenz als analoges Eingangssignal über die Eingangsleitung E zugeführt. Über den analogen Ausgang A wird ein analoges Ausgangssignal abgegeben, sinngemäss über den digitalen Ausgang D ein digitales Ausgangssignal. Die Schaltung besteht aus einer Reihe von Bauteilen oder Elementen, im wesentlichen je einem Phasendetektor 2, einem Regler 3, einem Analog-Digital-Umsetzer oder -Wandler 4, ein oder zwei Phasenakkumulatoren 5 und/oder 10, einem Tiefpass-Filter 6, einem Digital-Analog-Wandler 7, einer Lookup-Tabelle 8, einer vorzugsweise quarzstabilisierten Systemuhr 13, einem Referenz-Register 11 oder einem anderem Speicher zur Speicherung der Referenzfrequenz, einer Schnittstelle zu einem Computer 12. Die Lookup-Tabelle 8 kann, ebenso wie andere Elemente, auch an anderer Stelle der Schaltung angeordnet sein, beispielsweise als separates Bauteil. Andererseits kann die Computer-Schnittstelle 12 auch durch einen in die Schaltung integrierten Prozessor ersetzt werden.

Das zu messende elektrische Eingangssignal, eine analoge Schwingung, wird vom selbstschwingenden Sensor 1 der Schaltung über Eingangsleitung E zugeführt. Der Phasendetektor 2 erzeugt ein Niederfrequenzsignal, das proportional zur Phasendifferenz zwischen dem analogem Eingangssignal und dem am Ausgang des Tiefpass-Filters 6 anliegenden Signal ist. Das Ausgangssignal des Phasendetektors, d.h. der Phasenfehler, wird zum Regler 3 geführt. Wird als Regler 3 ein reiner Proportionalregler eingesetzt, so hat man einen bleibenden Phasenfehler. Wird jedoch ein Regler mit Integralteil verwendet, so wird dieser Phasenfehler gleich Null. Hier im Beispiel wird ein Proportionalregler verwendet. Das analoge Signal am Ausgang des Reglers 3 entspricht nun der Frequenzabweichung zwischen der Frequenz des analogen Eingangssignals auf E und der im Register 11 gespeicherten Referenzfrequenz. Dieser kann nun als analoges Signal über Ausgangsleitung A oder - hinter dem Analog-Digital-Wandler 4 - als digitales Signal auf Ausgangsleitung D benutzt werden. Eingangs genannte Beispiele sind die Signalauswertung von Rastersondenmikroskopen oder bei der Thermo-Gravimetrie.

Der erste Phasenakkumulator 5 bildet aus der digitalisierten Frequenzabweichung eine digitale Phasenabweichung, die zur im zweiten Phasenakkumulator 11 akkumulierten Referenzfrequenz addiert wird. Mittels der Lookup-Tabelle 8, die üblicherweise die zu digitalen Sägezahnwerten (wie sie die Phasenakkumulatoren erzeugen) gehörenden digitalen Sinuswerte enthält, und des nachgeschalteten Digital-Analog-Wandlers 7 wird daraus eine analoge Sinusschwingung erzeugt, deren Verlauf durch das Tiefpassfilter 6 geglättet werden kann. Dank der vorgesehenen, quarzstabilisierten Systemuhr 13, die die Phasenakkumulatoren 5 und 12 wie die Wandler 4 und 7 taktet, weist das Signal am Ausgang des Tiefpassfilters 6 grosse Temperaturunempfindlichkeit und sehr gute Langzeitstabilität auf.

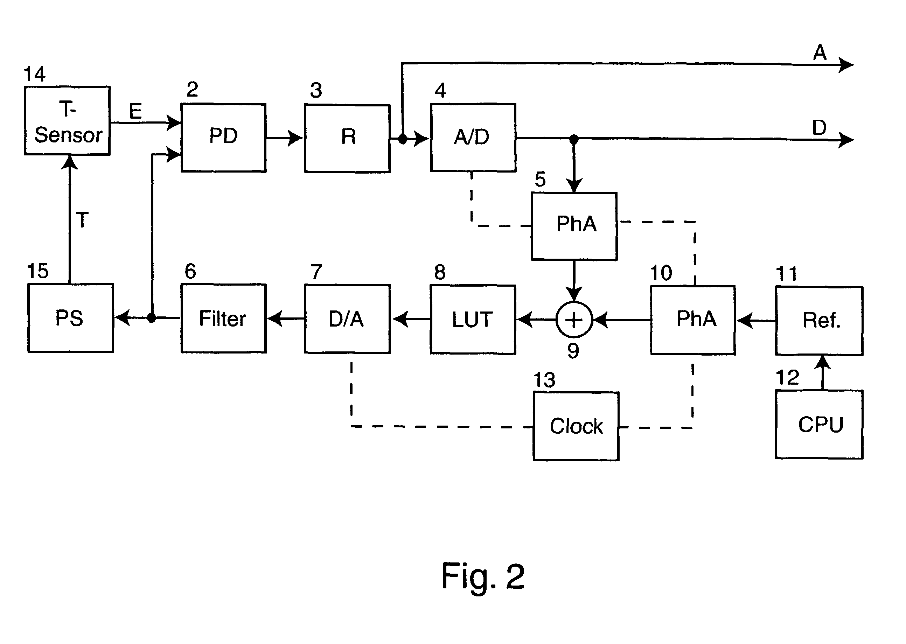

Die in Fig. 1 gezeigte Schaltung lässt sich auch so variieren, dass nur ein einziger Phasenakkumulator hinter dem Addierglied 9 vorgesehen ist, in dem die erforderliche Phasenakkumulation nach der Summation durchgeführt wird. Gleiches gilt sinngemäss für die in Fig. 2 gezeigte Schaltung.

Auch kann der digitale Teil der Schaltung, also insbesondere die Phasenakkumulatoren 5 und 10, die Systemuhr 13, die Lookup-Tabelle 8, sowie das Register 11 für die Referenzfrequenz, auf einem Digitalrechner oder mit Hilfe eines sog. Direct Digital Synthesizers (DDS) zumindest teilweise implementiert werden. Insbesondere eine Lösung mit einem DDS erscheint vorteilhaft, da solche DDS als integrierte Schaltungen im Handel zur Verfügung stehen.

Obwohl die Bemessung der gesamten Schaltung für die Fachperson keine Schwierigkeiten bietet, seien hier noch einige Angaben zu typischen Frequenzen und Grenzwerten gemacht. So liegt beispielsweise eine typische Eigenresonanz eines Sensors für ein Rastersondenmikroskop im Bereich 32 kHz. Eine dazu passende Taktfrequenz der Systemuhr 13 liegt dann bei 24 MHz. Die dazu erforderliche Lookup-Tabelle hat eine Grösse von etwa 4000 Einträgen. Die Bittiefen der beiden Wandler liegen zwischen 10 und 16 Bit; die Busbreite eines Phasenakkumulators bei beispielsweise 32 Bit.

Eine oben bereits erwähnte weitere Möglichkeit zur Messung der Resonanzfrequenverschiebung besteht darin, dass man einen Sensor mit einer externen Frequenz antreibt. Ein entsprechender Sensor erzeugt dann ein phasenverschobenes Ausgangsignal, dessen Phasenverschiebung abhängig von der Resonanzfrequenz des Sensors ist. Somit kann mit einer modifizierten Version der oben beschriebenen Schaltung wiederum die Resonanzfrequenz des Sensors gemessen werden.

Eine entsprechend modifizierte Schaltung ist in Fig. 2 als Blockdiagramm gezeigt. Darin hat der fremdangetriebene Sensor 14 den selbstschwingenden Sensor 1 aus Fig. 1 ersetzt und ein Phasenschieber 15 ist als neues Element hinzugekommen.

Der Phasenschieber 15 erzeugt die antreibende Frequenz für den Sensor 14 aus dem Ausgangssignal des Tiefpassfilters 6, das ja, wie oben beschrieben, eine analoge Sinusschwingung erzeugt. Sensor 14 nimmt diese Frequenz über Treiberleitung T auf und erzeugt daraus gemäss seinem Frequenzübertragungsverhalten an seinem Ausgang eine frequenzgleiche, aber mehr oder weniger phasenverschobene, analoge Ausgangsschwingung. Dieses Signal auf Eingangsleitung E wird vom Phasendetektor 2 mit der ursprünglichen Phasenlage des Signals am Ausgang des Tiefpassfilters 6 verglichen und ein Phasenfehlersignal erzeugt, das an den Regler 3 weitergegeben wird. Dieser ist hier typischerweise als Regler mit Integralteil implementiert. Dadurch wird das den Sensor 14 antreibende Signal auf Leitung T immer so nachgeregelt, dass die Phasendifferenz an den Eingängen des Phasendetektors 2 gleich Null sind. Wird nun der Phasenschieber 15 so eingestellt, dass er exakt die Phasenverschiebung des Sensors 14 bei Resonanzfrequenz kompensiert, so erzeugt der Regler 3 an seinem Ausgang wiederum - wie oben im Zusammenhang mit Fig. 1 beschrieben - ein analoges Signal, welches exakt die Frequenzdifferenz zwischen der Referenzfrequenz im Register 11 und der Resonanzfrequenz des Sensors 14 widerspiegelt. Am Ausgang vom Analog-Digital-Wandler 4 erhält man auch hier eine numerische Form dieser Frequenzdifferenz.

Gegenüber der ersten, im Zusammenhang mit Fig. 1 beschriebenen Version hat diese Methode den Vorteil, dass damit sehr einfach Sensoren mit mehreren Resonanzfrequenzen verwendet werden können, da die Einstellung auf verschiedene Frequenzen offensichtlich unproblematisch ist. Auch die Verwendung von Sensoren, die nur sehr schwer oder gar nicht selbstschwingend betrieben werden können, aber sich aus anderen Gründen für einen angestrebten Verwendungszweck eignen, ist nun ohne weiteres möglich. Beispiele hierfür sind Sensoren mit nahe beieinander liegenden Resonanzfrequenzen oder Anordnungen mit mehreren Sensoren, die im Zeit- oder Frequenzmultiplex-Verfahren betrieben und mit einer gemeinsamen Detektorschaltung ausgewertet werden.

Natürlich lässt sich diese einfache und robuste Schaltung bei prinzipiell gleicher oder ähnlicher Wirkungsweise modifizieren, dies sollte eine Fachperson ohne Schwierigkeiten durchführen können.

## Patentansprüche

1. Elektronische Frequenzmesseinrichtung, insbesondere zur Präzisionsmessung kleiner Frequenzdifferenzen, für analoge, von einem Sensor gelieferte Signale,
**dadurch gekennzeichnet, dass** sie folgende Baugruppen enthält:
- eine analoge Eingangsgruppe (2, 3), der ein Signal mit einer zu messenden Eingangsfrequenz und ein analoges Rückkopplungssignal zugeführt werden und die daraus ein die Frequenzdifferenz zwischen Eingangsfrequenz und einer gegebenen Referenzfrequenz abbildendes, analoges Differenzsignal bildet,
- eine digitalen Mischgruppe (5, 8 -11), die die Abweichung des Differenzsignals von der Referenzfrequenz als digitale Frequenzdifferenz ermittelt, und
- eine analoge Ausgangsgruppe (6), die aus der digitalen Frequenzdifferenz das Rückkopplungssignal bildet.

2. Elektronische Frequenzmesseinrichtung nach Anspruch 1,
**dadurch gekennzeichnet, dass**
- die analoge Eingangsgruppe einen Frequenzvergleicher und einen Regler (3) enthält, dessen Ausgang mit einem Analog/Digital-Umsetzer (4) verbunden ist,
- der Ausgang des Reglers (3) einen Analog-Ausgang (A) der Frequenzmesseinrichtung und/oder
- der Ausgang des Analog/Digital-Umsetzers (4) einen Digital-Ausgang (D) der Frequenzmesseinrichtung bilden.

3. Elektronische Frequenzmesseinrichtung nach Anspruch 2,
**dadurch gekennzeichnet, dass**
- der Frequenzvergleicher in der analogen Eingangsgruppe als Phasenfehlerdetektor (2) ausgebildet ist.

4. Elektronische Frequenzmesseinrichtung nach Anspruch 2 oder 3,
**dadurch gekennzeichnet, dass**
- die digitale Mischgruppe zumindest eine gespeicherte Referenzfrequenz (11) enthält,
- dazu zumindest ein Phasenakkumulator (5 oder 10) für die Akkumulation von Digitalwerten der Referenzfrequenz und/oder der Differenzfrequenz und
- eine Tabelle (8) für die Ermittlung einer dem aktuellen Phasenwert eines ermittelten Frequenzsignals entsprechenden, aktuellen Werts einer periodischen Funktion.

5. Elektronische Frequenzmesseinrichtung nach Anspruch 2 oder 3,
**dadurch gekennzeichnet, dass**
- die digitale Mischgruppe zumindest eine gespeicherte Referenzfrequenz (11) enthält,
- dazu ein Addierglied (9) zum Summieren von Digitalwerten der Referenzfrequenz und der Differenzfrequenz,
- einen Phasenakkumulator für die Akkumulation der summierten Digitalwerte, und
- eine Tabelle (8) für die Ermittlung einer dem aktuellen Phasenwert eines ermittelten Frequenzsignals entsprechenden, aktuellen Werts einer periodischen Funktion.

6. Elektronische Frequenzmesseinrichtung nach zumindest einem der vorhergehenden Ansprüche, **dadurch gekennzeichnet, dass**
- die analoge Ausgangsgruppe einen Digital/Analog-Umsetzer (7) aufweist, dessen Ausgangs mit einem Filter (6), vorzugsweise einem Tiefpassfilter, verbunden ist, der das analoge Rückkopplungssignal erzeugt.

7. Elektronische Frequenzmesseinrichtung nach zumindest einem der vorhergehenden Ansprüche, **dadurch gekennzeichnet, dass**
- ein stabiler, vorzugsweise quarzstabilisierter System-Taktgeber (13) vorgesehen ist, der zumindest einen Phasenakkumulator (5, 10) und/oder zumindest einen der Umsetzer (4, 7) taktet.

8. Elektronische Frequenzmesseinrichtung nach zumindest einem der Ansprüche 2 bis 6, **dadurch gekennzeichnet, dass**
- der in der analogen Eingangsgruppe enthaltene Regler (3), dessen Ausgang mit einem Analog/Digital-Umsetzer (4) verbunden ist, als PI-Regler ausgebildet ist.

9. Elektronische Frequenzmesseinrichtung nach zumindest einem der Ansprüche 2 bis 6, **dadurch gekennzeichnet, dass**
der in der analogen Eingangsgruppe enthaltene Regler (3), dessen Ausgang mit einem Analog/Digital-Umsetzer (4) verbunden ist, als Proportional-Regler oder als Integral-Regler ausgebildet ist.

10. Elektronische Frequenzmesseinrichtung nach zumindest einem der vorhergehenden Ansprüche, **dadurch gekennzeichnet, dass**
- eine Baugruppe vorgesehen ist, die neben der analogen Eingangsgruppe einen oszillierenden Sensor (1) umfasst, insbesondere einen selbstschwingender Sensor, dessen analoges Ausgangssignal das Signal mit der zu messenden Eingangsfrequenz ist.

11. Elektronische Frequenzmesseinrichtung nach zumindest einem der vorhergehenden Ansprüche, **dadurch gekennzeichnet, dass**
- ein Phasenschieber (15) vorgesehen ist, der an ein Filter (6) am Ausgang der analogen Ausgangsgruppe angeschlossen ist und ein phasenverschobenes Ausgangssignal zum Betrieb eines Sensors (1), insbesondere eines nicht selbstschwingenden Sensors (14), erzeugt.

12. Verwendung einer elektronische Frequenzmesseinrichtung nach zumindest einem der Ansprüche 1 bis 11, **dadurch gekennzeichnet, dass**
- sie Teil eines Rastersondenmikroskop-Systems ist, vorzugsweise zumindest partiell in ein solches System integriert ist.

## Claims

1. An electronic frequency measuring device, in particular for precision measuring of small frequency differences, for analog signals provided by a sensor, **characterised in that** it comprises the following groups of components:
- an analog input group (2, 3) which is supplied with a signal with an input frequency to be measured and an analog feedback signal, said input group forming an analog difference signal therefrom, which signal depicts the difference between the input frequency and a given reference frequency;
- a digital mixing group (5, 8-11) which determines the deviation of the difference signal from the reference frequency as a digital frequency difference; and
- an analog output group (6) which forms the feedback signal from the digital frequency difference.

2. The electronic frequency measuring device according to claim 1, **characterised in that**
- the analog input group comprises a frequency comparator and a controller (3) whose output is connected to an analog to digital converter (4);
- whereby the output of the controller (3) forms an analog output (A) of the frequency measuring device; and/or
- the output of the analog to digital converter (4) forms a digital output (D) of the frequency measuring device.

3. The electronic frequency measuring device according to claim 2, **characterised in that**
- the frequency comparator in the analog input group is a phase error detector (2).

4. The electronic frequency measuring device according to claim 2 or 3, **characterised in that**
- the digital mixing group comprises at least one stored reference frequency (11);
- and in addition at least one phase accumulator (5 or 10) for accumulating digital values of the reference frequency and/or the difference frequency; and
- a table (8) for determining a current value of a periodic function which corresponds to the current phase value of a determined frequency signal.

5. The electronic frequency measuring device according to claim 2 or 3, **characterised in that**
- the digital mixing group comprises at least one stored reference frequency (11);
- and in addition an adding element (9) for adding up digital values of the reference frequency and the difference frequency;
- a phase accumulator for accumulating the added up digital values; and
- a table (8) for determining a current value of a periodic function which corresponds to the current phase value of a determined frequency signal.

6. The electronic frequency measuring device according to at least one of the preceding claims, **characterised in that**
- the analog output group comprises a digital to analog converter (7) whose output is connected to a filter (6), preferably a low pass filter, which generates the analog feedback signal.

7. The electronic frequency measuring device according to at least one of the preceding claims, **characterised in that**
- a stable, preferably quartz-stabilised, system clock generator (13) is provided which pulses at least one phase accumulator (5, 10) and/or at least one of the converters (4, 7).

8. The electronic frequency measuring device according to at least one of claims 2 to 6, **characterised in that**
- the controller (3) which forms part of the analog input group and whose output is connected to an analog to digital converter (4) is a PI controller.

9. The electronic frequency measuring device according to at least one of claims 2 to 6, **characterised in that**
- the controller (3) which forms part of the analog input group and whose output is connected to an analog to digital converter (4) is a proportional controller or an integral controller.

10. The electronic frequency measuring device according to at least one of the preceding claims, **characterised in that**
- componentry is provided which apart from the analog input group comprises an oscillating sensor (1), in particular a self-oscillating sensor, whose analog output signal is the signal with the input frequency to be measured.

11. The electronic frequency measuring device according to at least one of the preceding claims, **characterised in that**
- a phase shifter (15) is provided which is connected to a filter (6) of the analog output group and which generates an out-of-phase output signal for operating a sensor (1), in particular a non self-oscillating sensor (14).

12. The use of an electronic frequency measuring device according to at least one of claims 1 to 11, **characterised in that**
- it forms part of a scanning probe microscope system, preferably being at least partially integrated in such a system.

## Revendications

1. Dispositif électronique de mesure de fréquence, notamment pour la mesure de précision de petites différences de fréquence pour des signaux analogiques fournis par un capteur,
**caractérisé en ce qu'**il comprend les ensembles suivants:
- un groupe analogique d'entrée (2, 3) auquel sont communiqués un signal avec une fréquence d'entrée à mesurer et un signal analogique de rétrocouplage, et qui constitue à partir de là un signal analogique différentiel représentant la différence de fréquence entre la fréquence d'entrée et une fréquence de référence donnée,
- un groupe numérique d'interconnexion (5, 8 à 11) qui détermine l'écart du signal différentiel par rapport à la fréquence de référence sous forme d'une différence de fréquence numérique, et
- un groupe analogique de sortie (6) qui constitue, à partir de la différence de fréquence numérique, le signal de rétrocouplage.

2. Dispositif électronique de mesure de fréquence selon la revendication 1,
**caractérisé en ce que**
- le groupe analogique d'entrée contient un comparateur de fréquence et un régulateur (3) dont la sortie est raccordée à un convertisseur analogique-numérique (4),
- la sortie du régulateur (3) constitue une sortie analogique (A) du dispositif de mesure de fréquence et/ou
- la sortie du convertisseur analogique-numérique (4) constitue une sortie numérique (D) du dispositif de mesure de fréquence.

3. Dispositif électronique de mesure de fréquence selon la revendication 2,
**caractérisé en ce que**
- le comparateur de fréquence est réalisé dans le groupe analogique d'entrée sous forme de détecteur de défaut de phase (2).

4. Dispositif électronique de mesure de fréquence selon la revendication 2 ou 3,
**caractérisé en ce que**
- le groupe numérique d'interconnexion contient au moins une fréquence de référence enregistrée (11),
- et en outre au moins un accumulateur de phase (5 ou 10) pour l'accumulation de valeurs numériques de la fréquence de référence et/ou de la fréquence différentielle et
- une table (8) pour la détermination d'une valeur actuelle d'une fonction périodique correspondant à la valeur de phase actuelle d'un signal de fréquence déterminé.

5. Dispositif électronique de mesure de fréquence selon la revendication 2 ou 3,
**caractérisé en ce que**
- le groupe numérique d'interconnexion contient au moins une fréquence de référence enregistrée (11),
- et en outre un élément additionneur (9) pour la sommation de valeurs numériques de la fréquence de référence et de la fréquence différentielle,
- un accumulateur de phase pour l'accumulation des valeurs numériques additionnées, et
- une table (8) pour la détermination d'une valeur actuelle d'une fonction périodique correspondant à la valeur de phase actuelle d'un signal de fréquence déterminé.

6. Dispositif électronique de mesure de fréquence selon au moins l'une quelconque des revendications précédentes,
**caractérisé en ce que**
- le groupe de sortie analogique présente un convertisseur numérique/analogique (7) dont la sortie est raccordée à un filtre (6), de préférence un filtre passe-bas, qui génère le signal analogique de rétrocouplage.

7. Dispositif électronique de mesure de fréquence selon au moins l'une quelconque des revendications précédentes,
**caractérisé en ce que**
- il est prévu un générateur d'impulsions de système stable (13), de préférence stabilisé au quartz, qui génère des impulsions pour au moins un accumulateur de phase (5, 10) et/ou au moins un des convertisseurs (4, 7).

8. Dispositif électronique de mesure de fréquence selon au moins l'une quelconque des revendications 2 à 6,
**caractérisé en ce que**
- le régulateur (3) intégré dans le groupe analogique d'entrée (3), dont la sortie est raccordée à un convertisseur analogique/numérique (4), est réalisé sous forme de régulateur PI.

9. Dispositif électronique de mesure de fréquence selon au moins l'une quelconque des revendications 2 à 6,
**caractérisé en ce que**
- le régulateur (3) intégré dans le groupe analogique d'entrée (3), dont la sortie est raccordée à un convertisseur analogique/numérique (4), est réalisé sous forme de régulateur proportionnel ou de régulateur intégral.

10. Dispositif électronique de mesure de fréquence selon au moins l'une quelconque des revendications précédentes,
**caractérisé en ce que**
- il est prévu un ensemble qui, outre le groupe analogique d'entrée, comprend un capteur oscillant (1), notamment un capteur auto-oscillant, dont le signal analogique de sortie est le signal présentant la fréquence d'entrée à mesurer.

11. Dispositif électronique de mesure de fréquence selon au moins l'une quelconque des revendications précédentes,
**caractérisé en ce que**
- il est prévu un déphaseur (15) qui est raccordé à un filtre (6) à la sortie du groupe analogique de sortie et génère un signal de sortie à phase décalée pour faire fonctionner un capteur (1), notamment un capteur non auto-oscillant (14).

12. Dispositif électronique de mesure de fréquence selon au moins l'une quelconque des revendications 1 à 11,
**caractérisé en ce que**
- il fait partie d'un système de microscope par sonde à balayage, à savoir est de préférence du moins partiellement intégré dans un tel système.
